# EUROPEAN PATENT SPECIFICATION

(11) **EP 2 708 847 B1**
(45) Date of publication and mention of the grant of the patent: **11.09.2019**
(21) Application number: 13183882.3
(22) Date of filing: 11.09.2013
(51) Int. Cl.: G01B 21/04, G06T 17/00, G06T 19/20

(54) **Method, system and program for generating a three-dimensional model**
Verfahren, System und Programm zur Erzeugung eines dreidimensionalen Modells
Procédé, système et programme de génération d'un modèle tridimensionnel

(30) Priority: 14.09.2012 JP 2012203626
(43) Date of publication of application: 19.03.2014
(73) Proprietor: Mitutoyo Corporation, Kawasaki-shi, Kanagawa 213-8533 (JP)
(72) Inventor: Asamizu, Takanori, Kanagawa, 213-8533 (JP); Tomono, Yasushi, Kanagawa, 213-8533 (JP)
(74) Representative: Gill Jennings & Every LLP

(56) References cited:
- US-A- 6 128 405
- US-A1- 2008 012 851
- US-A1- 2008 052 036

## Description

### BACKGROUND OF THE INVENTION

### 1. Field of the Invention

The present invention relates to a method, a system, and a program of generating a three-dimensional (3D) model in which a 3D model is generated on a CAD system from measurement data obtained from measurement of a measured object by a 3D measurement device.

### 2. Description of Related Art

As a method of reverse engineering or a method of designing a product without significant correction, a technology is conventionally known that generates a 3D model on a CAD system automatically from measurement data obtained from measurement of a measured object by a 3D measurement device. In a technology disclosed in Japanese Patent Laid-Open Publication No. 2003-345839, for example, surface data that represent a surface of a measured object are generated from measurement data (point group data) obtained from measurement of the measured object; the surface data are connected to generate face data that represent a continuous surface; and then a 3D solid model is generated from a boundary represented surface model.

In the above-described conventional method of generating a 3D model, however, a measurement error in measurement of a measured object by a 3D measurement device or an error in converting from measurement data to surface data may lead to a failure in connection of the surface data, due to misalignment in connection points, and difficulty in generation of an accurate 3D model.

To address these circumstances, conventional processing includes manually or automatically selecting a boundary line between surface data for merge processing to provide a closed space (close processing) and automatically generating a closed 3D model directly from all surface data based on an assumption that all generated surface data close. This causes a significant difference between a generated 3D model and an actual measured object, and thus requires an enormous amount of time for correction thereafter.

### SUMMARY OF THE INVENTION

In view of the circumstances above, the present invention provides a method, a system, and a program of generating a 3D model capable of generating an accurate 3D model from measurement data without significant correction.

An aspect of the present invention provides a method of generating a 3D model including entering, by a computing device, measurement data for a plurality of surface elements, the measurement data including measurement point group data obtained from measurement of a measured object, a type of surface element, and a geometry value of a surface element; for at least one of the plurality of surface elements, calculating, by the computing device, a measurement data error based on the surface element specified by the measurement data, wherein the calculated measurement data error is based on one or both of an existing width of the measurement point group data in the surface element specified by the measurement data, and an angle error of one of a surface and an axis of the surface element specified by the measurement data relative to one of a reference surface and a reference axis; determining, by the computing device, whether the calculated error is within a predetermined tolerance; correcting, by the computing device, the surface element by the error when the error is within the tolerance; and obtaining intersection data of the plurality of surface elements and outline data of each surface element from the corrected surface elements to generate a 3D model by the computing device. Accordingly, a method of generating the 3D model can be achieved in which an accurate 3D model is generated from the measurement data without significant correction.

In the method of generating the 3D model above, the calculated measurement data error can be an existing width of the measurement point group data in the surface element specified by the measurement data, or may be an angle error of one of a surface and an axis of the surface element specified by the measurement data relative to one of a reference surface and a reference axis. In addition, in the method of generating the 3D model above, when both the existing width and the angle error are within the tolerances, a position of the surface element may be corrected so as to be aligned with one of the reference surface and the reference axis, the existing width being of the measurement point group data in the surface element specified by the measurement data, the angle error being of one of the surface and the axis of the surface element specified by the measurement data relative to one of the reference surface and the reference axis.

When the surface element is a plane surface element, the existing width of the measurement point group may be determined in an area where the measurement point group data are projected in the surface element specified by the geometry value of the surface element. When the surface element is one of a cylindrical element and a conical element, the existing width of the measurement point group may be determined in an area where the measurement point group data are projected in an axis of the surface element specified by the geometry value of the surface element. Furthermore, the angle error of the surface element relative to one of the reference surface and the reference axis may be determined based on whether an angle error relative to an angle of 90° is equal to or less than a predetermined threshold value for right angle determination or an angle error relative to an angle of 0° is equal to or less than a predetermined threshold value for one of parallel and identical determination. The determination and correction may be performed in a priority order of being identical, parallel, and at a right angle.

The calculated error of the measurement data may be a numerical value equal to or less than a predetermined number of decimal places of a radius value of a rotational two-dimensional curved surface element, including a cylinder, a cone, a sphere, and a torus, specified by the measurement data. Correction of the surface element may be a process in which the numerical value equal to or less than the predetermined number of digits is rounded.

Another aspect of the present invention provides a 3D model generation system generating a 3D model of an object on a CAD system, the 3D model generation system including an inputter entering measurement data for a plurality of surface elements, the measurement data including measurement point group data obtained from measurement of the object, a type of surface element, and a geometry value of a surface element; a determiner calculating for at least one of the plurality of surface elements a measurement data error based on the surface element specified by the measurement data, wherein the calculated measurement data error is based on one or both of an existing width of the measurement point group data in the surface element specified by the measurement data, and an angle error of one of a surface and an axis of the surface element specified by the measurement data relative to one of a reference surface and a reference axis, and then determining whether the calculated error is within a predetermined tolerance; a surface element corrector correcting the surface element by the error when the error is within the tolerance; and a generator obtaining intersection data of the plurality of surface elements and outline data of each surface element from the corrected surface elements to generate a 3D model.

Another aspect of the present invention provides a 3D model generation program executed by a computer, the program including entering measurement data for a plurality of surface elements, the measurement data including measurement point group data obtained from measurement of a measured object, a type of surface element, and a geometry value of a surface element; calculating for at least one of the plurality of surface elements a measurement data error based on the surface element specified by the measurement data, wherein the calculated measurement data error is based on one or both of an existing width of the measurement point group data in the surface element specified by the measurement data, and an angle error of one of a surface and an axis of the surface element specified by the measurement data relative to one of a reference surface and a reference axis; determining whether the calculated error is within a predetermined tolerance; correcting the surface element by the error when the error is within the tolerance; and obtaining intersection data of the plurality of surface elements and outline data of each surface element from the corrected surface elements to generate a 3D model.

According to the present invention, an accurate 3D model can be generated from measurement data without significant correction.

### BRIEF DESCRIPTION OF THE DRAWINGS

The present invention is defined in the appended claims and it is further described in the detailed description which follows, in reference to the noted plurality of drawings by way of non-limiting examples of exemplary embodiments of the present invention, in which like reference numerals represent similar parts throughout the several views of the drawings, and wherein:
Fig. 1 is a block diagram illustrating a 3D model generation system using a 3D model generation program according to a first embodiment of the present invention;
Fig. 2 is a schematic view illustrating an example of measurement data obtained from the 3D model generation program;
Fig. 3 is a flowchart illustrating operations of the 3D model generation program;
Fig. 4 is a flowchart illustrating a method of angle determination according to the embodiment;
Fig. 5 is a schematic view illustrating a method of handling plane surface data using the angle determination;
Fig. 6 is a schematic view illustrating a method of handling cylindrical data using the angle determination;
Fig. 7 is a flowchart illustrating a method of width determination according to the embodiment; and
Fig. 8 is a flowchart illustrating a method of generating a solid model according to the embodiment.

### DETAILED DESCRIPTION OF PREFERRED EMBODIMENTS

The particulars shown herein are by way of example and for purposes of illustrative discussion of the embodiments of the present invention only and are presented in the cause of providing what is believed to be the most useful and readily understood description of the principles and conceptual aspects of the present invention. In this regard, no attempt is made to show structural details of the present invention in more detail than is necessary for the fundamental understanding of the present invention, the description is taken with the drawings making apparent to those skilled in the art how the forms of the present invention may be embodied in practice.

An embodiment according to the present invention is described below with reference to the drawings.

### First Embodiment

### [3D Model Generation System]

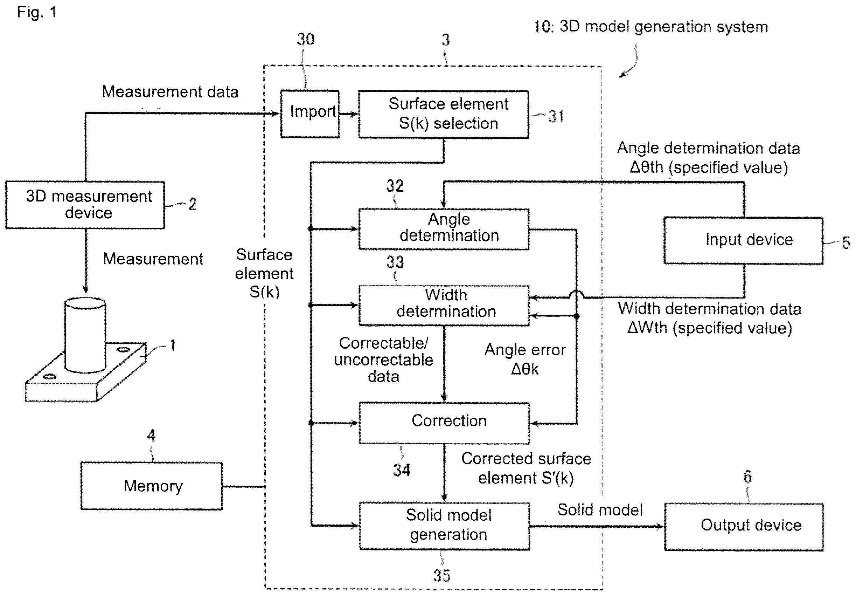

Fig. 1 is a block diagram illustrating a 3D model generation system 10 according to the present embodiment. The 3D model generation system 10 according to the present embodiment, for example, receives measurement data from a 3D measurement device 2 measuring a measured object 1 and generates a solid model based on CAD data. The 3D model generation system 10 is included in a CAD system as a portion thereof, for example. In the 3D model generation system 10, various functions are performed by a computer and a 3D model generation program executed by the computer. The 3D model generation system 10 has a computing device 3, a memory 4, an input device 5, and an output device 6. The computing device 3 receives measurement data, corrects a surface element, and then generates a solid model. The memory 4 is connected to the computing device 3. The input device 5 is connected to the computing device 3 and is provided to operate the 3D model generation program according to the present embodiment and to specify various parameters. The output device 6 outputs the solid model generated in the computing device 3. For the input device 5, a keyboard, a mouse, a touch panel, or the like can be employed. For the output device 6, a display, a printer, or the like can be employed.

In addition to a predetermined 3D model generation program, the computing device 3 has an importer 30, a surface element selector 31, an angle determiner 32, a width determiner 33, a corrector 34, and a solid model generator 35. The importer 30 receives measurement data from the 3D measurement device 2. The surface element selector 31 sequentially selects a surface element from the received measurement data. The angle determiner 32 determines an angle error of the selected surface element with respect to a reference surface or a reference axis. The width determiner 33 determines a width of the selected surface element. The corrector 34 corrects the surface element based on determination results of the angle determiner 32 and the width determiner 33. The solid model generator 35 generates a solid model based on corrected surface elements and uncorrected surface elements.

The measured object 1 may have any shape, including a free-form surface, but has a surface shape composed of a combination of a dot element, a straight line element, and a surface element, which are definable on a CAD system as an analytical quadratic curve or quadric surface, such as a dot, a straight line, a plane surface, a circle, an ellipse, a cylindrical surface, a conical surface, a spherical surface, and a toroidal surface. For purposes of explanation herein, the measured object 1 has a shape as shown in Fig. 1. Specifically, the measured object 1 has a shape that includes a rectangular parallelepiped and a cylinder extending upward from an upper surface of the rectangular parallelepiped. Four side surfaces and upper and lower surfaces of the rectangular parallelepiped are plane surfaces combined with one another at a right angle. A cylindrical hole is provided in each of two corner portions along a diagonal line.

The measurement data output from the 3D measurement device 2 include measurement point group data, a type of geometric element, and a geometry value of a geometric element. The measurement point group data are a measurement coordinate data group of one or a plurality of measurement points of a surface of the measured object 1. The type of geometric element is data that indicate a dot element, a straight line element, and a surface element of a dot, a straight line, a plane surface, a circle, an ellipse, a cylindrical surface, a conical surface, a spherical surface, and a toroidal surface. The type of geometric element may be data individually specified by an operator when obtaining measurement point group data during 3D measurement or data automatically determined by a 3D measurement device depending on a distribution status of measurement point group data (refer to Japanese Patent Laid-Open Publication No. 2001-241941, for example).

The geometry value of the geometric element is data of a reference position coordinate, a direction, a length, a radius, and the like of the geometric element estimated from measurement point group data. For instance, a straight line element includes a coordinate value of a reference point, a direction, a length, and the like; a plane surface element includes a coordinate value of a reference point, a normal direction, and the like; a circle element includes a coordinate value of a reference point, a normal direction, a radius, and the like; and an ellipse element includes a coordinate value of a reference point, a normal direction, a long diameter direction, a long diameter, a short diameter, and the like. The geometry value of the geometric element is obtained from the type of geometric element and the measurement point group data. For explanation purposes, the geometric element is hereafter a surface element.

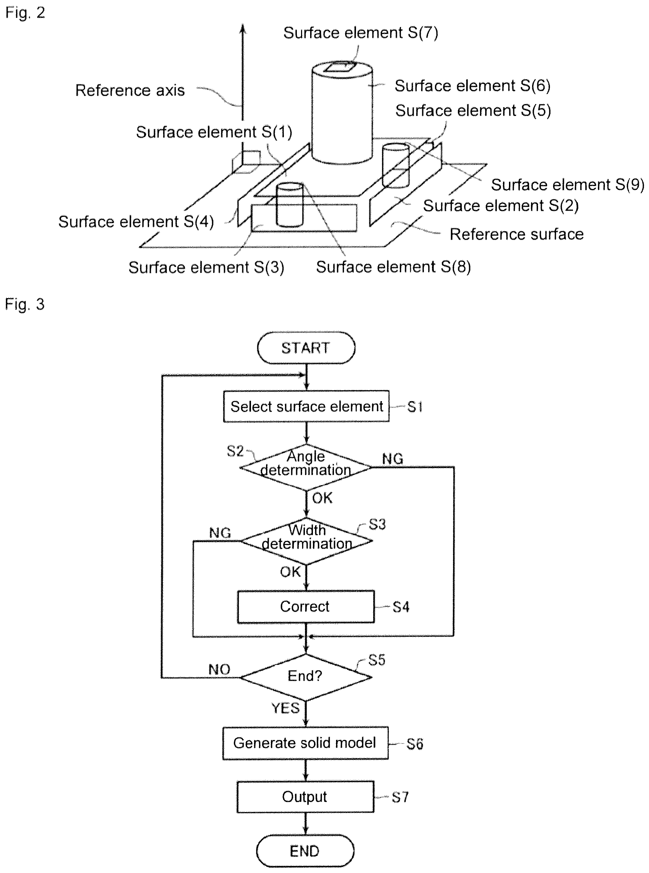

The measured object 1 shown in Fig. 1, for example, has surface elements S(1) to S(9) as shown in Fig. 2. With reference to Fig. 2, a size (length, width, height, and the like) of each of the surface elements S(1) to S(9) is unknown at a stage where the 3D model generation system 10 enters measurement data. The size is defined herein based on a distribution range of a measurement point group. The surface elements S(1) to S(5) are plane surface elements that represent four side surfaces and an upper surface (lower surface unmeasurable) of the rectangular parallelepiped portion of the measured object 1. Each of the surface elements S(1) to S(5) is specified by at least three measurement points in the same plane of the measured object 1. The surface element S(6) is a cylindrical surface element that represents a side surface of a cylindrical portion extending upward from the rectangular parallelepiped. The surface element S(7) is a plane surface element that represents an upper surface of the cylindrical portion. The surface elements S(8) and S(9) are cylindrical surface elements that represent side surface portions of the holes in the rectangular parallelepiped. Hereinafter, a surface on which the measured object 1 is placed is referred to as a reference surface, and a straight line perpendicular to the reference surface is referred to as a reference axis.

### [3D Model Generation Program]

An overview of the 3D model generation program according to the present embodiment is described below with reference to Figs. 1 and 3. Fig. 3 is a flowchart illustrating operations of the 3D model generation system 10 executed by the 3D model generation program according to the present embodiment. Specifically, in Step S1, the surface element selector 31 sequentially selects one surface element S(k) from measurement data of the surface elements S(1) to S(9) input through the importer 30. In Step S2, when the selected surface element S(k) is a plane surface element, the angle determiner 32 performs angle determination to determine whether or not an angle error Δθk between a plane surface specified by a geometry value thereof and the reference surface is equal to or less than angle determination data Δθth (specified value). When the selected surface element S(k) is a cylindrical surface element, a conical surface element, a toroidal element, or the like, the angle determiner 32 performs angle determination to determine whether or not an angle error Δθk between a center axis specified by a geometry value thereof and the reference axis is equal to or less than angle determination data Δθth. When the angle error Δθk is equal to or less than the predetermined angle determination data Δθth, the angle error data Δθk is output as a correction value.

In Step S3, the width determiner 33 determines an existing width of the measurement point group data with reference to the plane surface or curved surface specified by the geometry value of the selected surface element S(k). When the surface element is a plane surface element, the width determiner 33 determines the existing width of the measurement point group data in an area where the measurement point group data are projected in the surface element specified by the geometry value of the surface element. When the surface element is a cylindrical element or conical element, the width determiner 33 determines the existing width of the measurement point group data in an area where the measurement point group data are projected in an axis of the surface element specified by the geometry value of the surface element. The existing width of the measurement point group data is represented by a distance in a normal direction from the surface element specified by the geometry value to each measurement point. The width determiner 33 determines whether or not an existing width ΔWk of the measurement point group data is equal to or less than width determination data ΔWth (specified value), and outputs correctable/uncorrectable data as a width determination result. The angle determination data Δθth and the width determination data ΔWth can be specified in advance from the input device 5.

In subsequent Step S4, when the errors are equal to or less than the specified values in both the angle determination (Step S2) and the width determination (Step S3) above, the corrector 34 inputs the angle error Δθk, corrects the surface element S(k) by the angle error Δθk, and outputs the corrected surface element S'(k). As a result, the surface represented by the surface element S(k) is aligned so as to be identical, parallel, or perpendicular to the reference surface, or the center axis of the surface element S(k) is aligned so as to be identical, parallel, or perpendicular to the reference axis. When the angle error is determined to be greater than the angle determination data Δθth in the angle determination or the existing width is determined to be greater than the width determination data ΔWth in the width determination, no correction is made to the surface element S(k). According to the method above, the errors are corrected to allow generation of an accurate solid model. In addition, a situation can be prevented in which a surface intentionally inclined by design is erroneously recognized as an error and is corrected.

The sequence above is repeated for all the surface elements S(1) to S(9) (Step S5). Thereafter, the solid model generator 35 inputs the corrected surface elements S'(k) and uncorrectable surface elements S(m) and generates a solid model in Step S6, and then outputs the solid model to the output device 6 in Step S7.

### [Angle Determination in Step S2]

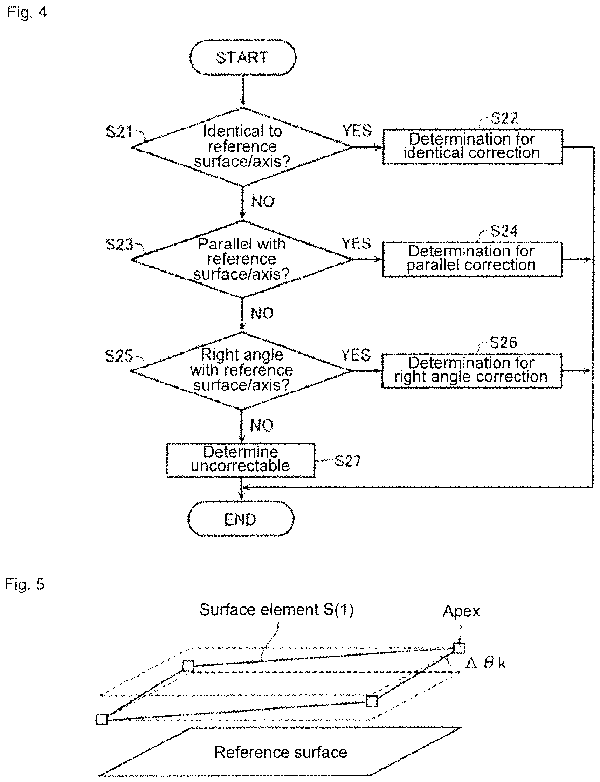

Each step of the 3D model generation program according to the present embodiment is described in further detail below. With reference to Fig. 4, a method of angle determination is described first. Fig. 4 is a flowchart illustrating the method of angle determination according to the embodiment.

In the angle determination in Step S2, it is first determined whether the surface element S(k) is identical to the reference surface (for a plane surface element) or the reference axis (for a cylindrical element, conical element, or the like) (Step S21). As a result, when the surface element S(k) is determined to be identical to the reference surface or reference axis, a determination for identical correction is output (Step S22). Whether the surface element S(k) is identical to the reference surface or reference axis is determined based on whether the angle error Δθk between the reference surface and the surface element S(k) is equal to or less than the angle determination data Δθth and whether a positional difference between the reference surface and the surface element S(k) is equal to or less than a predetermined value.

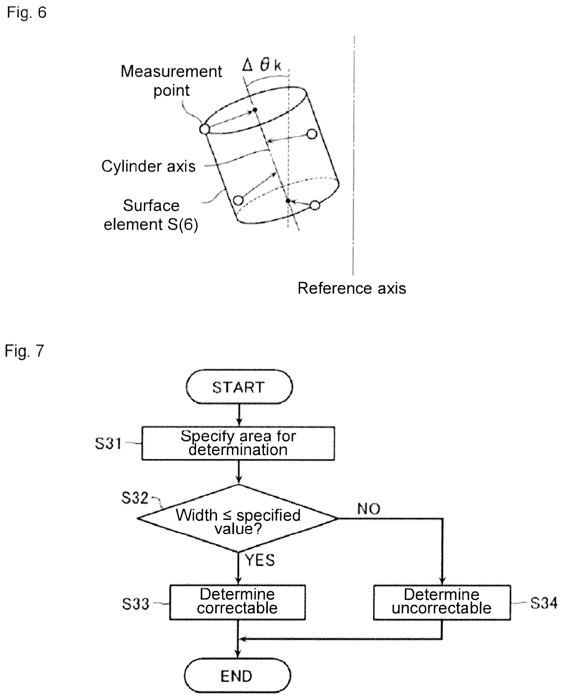

When the surface element is a plane surface element, such as, for example, the surface element S(1), the angle error Δθk between the reference surface and the surface element S(k) corresponds to an angle of the surface element S(1), specified by a geometry value, relative to the reference surface, as shown in Fig. 5. When the surface element S(k) is a cylindrical element, such as, for example, the surface element S(6), the angle error Δθk corresponds to an angle of a cylinder axis relative to the reference axis, as shown in Fig. 6, the cylinder axis being represented by the surface element S(k) specified by a geometry value.

When the surface element S(k) is not identical to the reference surface or reference axis, it is determined whether the surface element S(k) is parallel with the reference surface or reference axis (Step S23). As a result of the determination, when the surface element S(k) is determined to be parallel with the reference surface or reference axis, a determination for parallel correction is output (Step S24). Whether the surface element S(k) is parallel with the reference surface is determined based on whether the angle error Δθk between the reference surface and the surface element S(k) is equal to or less than the angle determination data Δθth, as shown in Fig. 5. When the surface element S(k) is a cylindrical element, a conical element, or the like, whether the surface element S(k) is parallel with the reference axis is determined based on whether the angle error Δθk between the reference axis and the cylinder axis of the surface element S(k) is equal to or less than the angle determination data Δθth, as shown in Fig. 6.

When the surface element S(k) is determined not to be parallel with the reference surface or reference axis in Step S23 above and the surface element S(k) is plane surface data, it is determined whether the surface element S(k) is at a right angle with the reference surface; when the surface element S(k) is cylindrical data, it is determined whether the cylinder axis of the surface element S(k) is at a right angle with the reference axis (Step S25). As a result, when the surface element S(k) is determined to be at a right angle with the reference surface or reference axis, a determination for right angle correction is output (Step S26). When the surface element S(k) is determined not to be at a right angle, an uncorrectable determination is output (Step S27). Whether the surface element S(k) is at a right angle with the reference surface or reference axis above is determined based on whether Δθk fulfills a relationship of 90°-Δθth ≤ Δθk ≤ 90°+Δθth.

In the method above, the angle of the surface element S(k) relative to the reference surface is determined in a priority order of being identical, parallel, and at a right angle. The angle determination above allows efficient grouping of element groups included in a 3D model and efficient automatic generation of an entire 3D solid model.

### [Width Determination in Step S3]

A method of width determination according to the present embodiment is described below with reference to Fig. 7. Fig. 7 is a flowchart illustrating the method of width determination according to the present embodiment.

In the width determination in Step S3, an area for determination is first specified (Step S31). When the surface element S(k) is a plane surface element, the area for determination is specified as below. Specifically, when the surface element is the plane surface element, an area where the measurement point group data are projected in the surface element specified by the geometry value of the surface element is specified as the area for determination. When the surface element is a cylindrical element or conical element, an area where the measurement point group data are projected in an axis of the surface element specified by the geometry value of the surface element is specified as the area for determination.

Then, a maximum value of a difference in distance in the normal direction from the surface element specified by the geometry value to each measurement point is defined as the existing width ΔWk of the measurement point group data. It is determined whether the existing width ΔWk is equal to or less than the width determination data ΔWth (Step S32). When the distance is equal to or less than the width determination data ΔWth, the surface element S(k) is determined to be correctable (Step S33). When the distance is greater than the width determination data ΔWth, the surface element S(k) is determined to be uncorrectable (Step S34).

### [Solid Model Generation in Step S6]

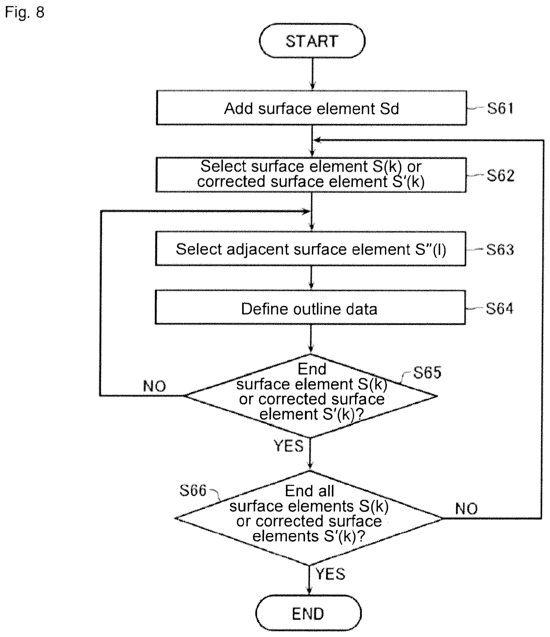

A method of generating a solid model according to the present embodiment is described below with reference to Fig. 8. In generation of the solid model according to the present embodiment, the lower surface of the measured object 1 is not measured in the present embodiment. Thus, a surface element Sd is first added as the lower surface of the measured object 1 (Step S61). Plane surface data identical to those of the reference surface are may be added for the element surface Sd. Then, the corrected surface elements S'(1) to S'(9) are sequentially selected (Step S62), and then the corrected surface elements S'(1) to S'(9) or the surface element Sd adjacent to the selected corrected surface elements S'(1) to S'(9) are sequentially selected as an adjacent surface element S"(1) (Step S63). Thereafter, lines of intersection between the selected corrected surface elements S'(1) to S'(9) and the adjacent surface element S"(1) are obtained by sweep processing, for example, and then are defined as outline data (for example, B-Reps) (Step S64). At this stage, when there is a line of intersection that intersects the defined lines of intersection, intersecting points of the lines of intersection are also defined. Steps S62 and S63 above are repeated for all adjacent surface elements S"(1) adjacent to the selected corrected surface elements S'(1) to S'(9) (Step S65). Furthermore, similar operations are performed for all the corrected surface elements S'(1) to S'(9) (Step S66). In the method above, the solid model can be generated automatically from 3D data. The solid model is generated as a 3D model in the present embodiment. However, the 3D model is not limited to the solid model, but may be a surface model or a wire model.

### Other Embodiments

In the first embodiment above, one reference surface and one reference axis are defined. However, the surface on which the measured object 1 is placed may be defined as a first reference surface; a surface perpendicular to the first reference surface may be defined as a second reference surface; a surface perpendicular to the first reference surface and the second reference surface may be a third reference surface; and a line of intersection between the first reference surface and the second reference surface, a line of intersection between the first reference surface and the third reference surface, and a line of intersection between the second reference surface and the third reference surface may be a first reference axis, a second reference axis, and a third reference axis, respectively. Thus, a side surface direction of the measured object can also be corrected.

It is noted that the foregoing examples have been provided merely for the purpose of explanation and are in no way to be construed as limiting of the present invention. While the present invention has been described with reference to exemplary embodiments, it is understood that the words which have been used herein are words of description and illustration, rather than words of limitation. Changes may be made, within the purview of the appended claims, as presently stated and as amended, without departing from the scope of the present invention in its aspects. Although the present invention has been described herein with reference to particular structures, materials and embodiments, the present invention is not intended to be limited to the particulars disclosed herein; rather, the present invention extends to all functionally equivalent structures, methods and uses, such as are within the scope of the appended claims.

The present invention is not limited to the above-described embodiments, and various variations and modifications may be possible without departing from the scope of the present invention.

## Claims

1. A method of generating a three-dimensional (3D) model, comprising:
entering, by a computer, measurement data for a plurality of surface elements, the measurement data including measurement point group data obtained from measurement of a measured object, a type of surface element, and a geometry value of a surface element;
for at least one of the plurality of surface elements, calculating, by the computer, a measurement data error based on the surface element specified by the measurement data, wherein the calculated measurement data error is based on one or both of an existing width of the measurement point group data in the surface element specified by the measurement data, and an angle error of one of a surface and an axis of the surface element specified by the measurement data relative to one of a reference surface and a reference axis;
determining, by the computer, whether the calculated error is within a predetermined tolerance;
correcting, by the computer, the surface element by the error when the error is within the tolerance; and
obtaining intersection data of the plurality of surface elements and outline data of each surface element from the corrected surface elements to generate a 3D model by the computer.

2. The method of generating the 3D model according to claim 1, wherein when the surface element is a plane surface element, the existing width of the measurement point group is determined in an area where the measurement point group data are projected in the surface element specified by the geometry value of the surface element, and when the surface element is one of a cylindrical element and a conical element, the existing width of the measurement point group is determined in an area where the measurement point group data are projected in an axis of the surface element specified by the geometry value of the surface element.

3. The method of generating the 3D model according to claim 1, wherein when both the existing width and the angle error are within the tolerances, a position of the surface element is corrected so as to be aligned with one of the reference surface and the reference axis, the existing width being of the measurement point group data in the surface element specified by the measurement data, the angle error being of one of the surface and the axis of the surface element specified by the measurement data relative to one of the reference surface and the reference axis.

4. The method of generating the 3D model according to claim 3, wherein when the surface element is a plane surface element, the existing width of the measurement point group is determined in an area where the measurement point group data are projected in the surface element specified by the geometry value of the surface element, and when the surface element is one of a cylindrical element and a conical element, the existing width of the measurement point group is determined in an area where the measurement point group data are projected in an axis of the surface element specified by the geometry value of the surface element.

5. The method of generating the 3D model according to any of claims 3 to 4, wherein the angle error of the surface element relative to one of the reference surface and the reference axis is determined based on whether an angle error relative to an angle of 90° is equal to or less than a predetermined threshold value for right angle determination or an angle error relative to an angle of 0° determination is equal to or less than a predetermined threshold value for one of parallel and identical determination, and correction are performed in a priority order of being identical, parallel, and at a right angle.

6. The method of generating the 3D model according to claim 1, wherein the calculated measurement data error is a numerical value equal to or less than a predetermined number of decimal places of a radius value of a rotational two-dimensional curved surface element, including a cylinder, a cone, a sphere, and a torus, specified by the measurement data, and correction of the surface element is a process in which the numerical value equal to or less than the predetermined number of digits is rounded.

7. A 3D model generation system generating a 3D model of an object on a CAD system, the 3D model generation system comprising:
an inputter configured to enter measurement data for a plurality of surface elements, the measurement data including measurement point group data obtained from measurement of the object, a type of surface element, and a geometry value of a surface element;
a determiner configured to calculate for at least one of the plurality of surface elements a measurement data error based on the surface element specified by the measurement data, wherein the calculated measurement data error is based on one or both of an existing width of the measurement point group data in the surface element specified by the measurement data, and an angle error of one of a surface and an axis of the surface element specified by the measurement data relative to one of a reference surface and a reference axis, and further configured to thereafter determine whether the calculated error is within a predetermined tolerance;
a surface element corrector configured to correct the surface element by the error when the error is within the tolerance; and
a generator configured to obtain intersection data of the plurality of surface elements and outline data of each surface element from the corrected surface elements to generate a 3D model.

8. A system according to claim 7 adapted to carry out a method according to any of claims 1 to 6.

9. At least one non-transitory computer readable medium for generating a 3D model, the medium comprising:
an entering code segment which, when executed by the computer, enters measurement data for a plurality of surface elements, the measurement data including measurement point group data obtained from measurement of a measured object, a type of surface element, and a geometry value of a surface element;
a calculating code segment which, when executed by the computer, calculates for at least one of the plurality of surface elements a measurement data error based on the surface element specified by the measurement data, wherein the calculated measurement data error is based on one or both of an existing width of the measurement point group data in the surface element specified by the measurement data, and an angle error of one of a surface and an axis of the surface element specified by the measurement data relative to one of a reference surface and a reference axis;
a determining code segment which, when executed by the computer, determines whether the calculated error is within a predetermined tolerance;
a correcting code segment which, when executed by the computer, corrects the surface element by the error when the error is within the tolerance; and
an obtaining code segment which, when executed by the computer, obtains intersection data of the plurality of surface elements and outline data of each surface element from the corrected surface elements to generate a 3D model.

## Patentansprüche

1. Ein Verfahren zur Erzeugung eines dreidimensionalen (3D) Modells, das folgendes umfasst:
Mit einem Computer Eingabe von Messdaten für eine Vielzahl an Oberflächenelementen, wobei zu den Messdaten Messpunktgruppendaten gehören, die durch Messen eines gemessenen Objekts, einer Art eines Oberflächenelements und einem geometrischen Wert eines Oberflächenelements erhalten werden;
Errechnen eines Messdatenfehlers basierend auf dem durch die Messdaten spezifizierten Oberflächenelement mit einem Computer für zumindest eines der Vielzahl an Oberflächenelementen, wobei der errechnete Messdatenfehler auf einer oder beiden einer vorhandenen Breite der Messpunktgruppendaten im durch die Messdaten spezifizierten Oberflächenelement und einem Winkelfehler von einer Oberfläche oder einer Achse des durch die Messdaten spezifizierten Oberflächenelements relativ zu entweder einer Bezugsfläche oder einer Bezugsachse basiert;
mit dem Computer Bestimmung, ob der errechnete Fehler innerhalb einer vorbestimmten Toleranz liegt;
mit dem Computer Korrigieren des Oberflächenelements durch den Fehler, wenn der Fehler innerhalb der Toleranz liegt; und
Erhalten von Schnittdaten der Vielzahl an Oberflächenelementen und Konturdaten jedes Oberflächenelements von den korrigierten Oberflächenelementen zur Erzeugung eines 3D-Modells durch den Computer.

2. Das Verfahren zur Erzeugung des 3D-Modells entsprechend Anspruch 1, wobei, wenn das Oberflächenelement ein Element mit ebener Fläche ist, die vorhandene Breite der Messpunktgruppe in einem Bereich bestimmt wird, wo die Messpunktgruppendaten im Oberflächenelement, das durch den geometrischen Wert des Oberflächenelements spezifiziert wird, projiziert werden, und wenn das Oberflächenelement ein zylindrisches Element oder ein kegelförmiges Element ist, die vorhandene Breite der Messpunktgruppe in einem Bereich bestimmt wird, wo die Messpunktgruppendaten in einer Achse des Oberflächenelements, die durch den geometrischen Wert des Oberflächenelements spezifiziert wird, projiziert werden.

3. Das Verfahren zur Erzeugung des 3D-Modells entsprechend Anspruch 1, wobei, wenn sowohl die vorhandene Breite und der Winkelfehler innerhalb der Toleranzen liegen, eine Position des Oberflächenelements korrigiert wird, damit sie auf entweder auf die Bezugsfläche oder die Bezugsachse ausgerichtet ist, wobei die vorhandene Breite zu den Messpunktgruppendaten im Oberflächenelement, das durch die Messdaten spezifiziert wird, gehört, wobei der Winkelfehler entweder zur Oberfläche oder zur Achse des Oberflächenelements, das durch die Messdaten relativ zur Bezugsfläche oder zur Bezugsachse spezifiziert wird, gehört.

4. Das Verfahren zur Erzeugung des 3D-Modells entsprechend Anspruch 3, wobei, wenn das Oberflächenelement ein Element mit ebener Fläche ist, die vorhandene Breite der Messpunktgruppe in einem Bereich bestimmt wird, wo die Messpunktgruppendaten im Oberflächenelement, das durch den geometrischen Wert des Oberflächenelements spezifiziert wird, projiziert werden, und wenn das Oberflächenelement ein zylindrisches oder kegelförmiges Element ist, die vorhandene Breite der Messpunktgruppe in einem Bereich bestimmt wird, wo die Messpunktgruppendaten in einer Achse des Oberflächenelements, das durch den geometrischen Wert des Oberflächenelements spezifiziert wird, projiziert werden.

5. Das Verfahren zur Erzeugung des 3D-Modells entsprechend Anspruch 3 bis 4, wobei der Winkelfehler des Oberflächenelements relativ zur Bezugsfläche oder zur Bezugsachse basierend darauf bestimmt wird, ob ein Winkelfehler relativ zu einem Winkel von 90° gleich oder weniger als ein vorbestimmter Schwellwert zur Bestimmung des rechten Winkels oder ein Winkelfehler relativ zu einer Bestimmung eines 0° Winkels gleich oder weniger als ein vorbestimmter Schwellwert für eine parallele oder identische Bestimmung ist, und Korrekturen in der Reihenfolge der Priorität, ob er identisch, parallel oder rechtwinklig ist, durchgeführt werden.

6. Das Verfahren zur Erzeugung des 3D-Modells entsprechend Anspruch 1, wobei der errechnete Messdatenfehler ein numerischer Wert gleich oder weniger als eine vorbestimmte Zahl an Dezimalstellen eines Radiuswerts eines zweidimensionalen, kurvenförmigen Rotationsoberflächenelements, einschließlich eines Zylinders, eines Kegels, einer Kugel und eines Rings, das durch die Messdaten spezifiziert wird, ist und die Korrektur des Oberflächenelements ein Prozess ist, bei dem der numerische Wert gleich oder weniger als die vorbestimmte Zifferzahl abgerundet wird.

7. Ein System zur Erzeugung eines 3D-Modells, das ein 3D-Modell eines Objekts auf einem CAD-System, wobei das System zur 3D-Modell-Erzeugung Folgendes umfasst:
ein Eingabegerät, das so konfiguriert ist, dass es die Messdaten für eine Vielzahl an Oberflächenelementen eingibt, wobei zu den Messdaten Messpunktgruppendaten gehören, die durch Messen eines Objekts, einer Art Oberflächenelement und einem geometrischen Wert eines Oberflächenelements, erhalten werden;
ein Bestimmungsgerät, das so konfiguriert ist, dass es einen Messdatenfehler basierend auf dem durch die Messdaten spezifizierten Oberflächenelement für zumindest eines der Vielzahl an Oberflächenelementen errechnet, wobei der errechnete Messdatenfehler auf einer oder beiden einer vorhandenen Breite der Messpunktgruppendaten im durch die Messdaten spezifizierten Oberflächenelement und einem Winkelfehler von einer Oberfläche oder einer Achse des durch die Messdaten spezifizierten Oberflächenelements relativ zu entweder einer Bezugsfläche oder einer Bezugsachse basiert, und zudem so konfiguriert ist, dass es danach bestimmt, ob der errechnete Fehler innerhalb einer vorbestimmten Toleranz liegt;
ein Korrigiergerät für das Oberflächenelement, das so konfiguriert ist, dass es das Oberflächenelement durch den Fehler korrigiert, wenn der Fehler innerhalb der Toleranz liegt;
ein Erzeugungsgerät, das so konfiguriert ist, dass es Schnittdaten der Vielzahl an Oberflächenelementen und Konturdaten jedes Oberflächenelements von den korrigierten Oberflächenelementen zur Erzeugung eines 3D-Modells erhält.

8. Ein System entsprechend Anspruch 7, das so adaptiert ist, dass es ein Verfahren entsprechend einem der Ansprüche 1 bis 6 durchführt.

9. Zumindest ein nicht flüchtiges, computerlesbares Medium zur Erzeugung eines 3D-Modells, wobei das Medium Folgendes umfasst:
ein Eingabecodesegment, das, wenn vom Computer ausgeführt, die Messdaten für eine Vielzahl an Oberflächenelementen eingibt, wobei zu den Messdaten Messpunktgruppendaten gehören, die durch Messen eines Objekts, einer Art Oberflächenelement und einem geometrischen Wert eines Oberflächenelements, erhalten werden;
ein Errechnungscodesegment, das, wenn vom Computer ausgeführt, einen Messdatenfehler basierend auf dem durch die Messdaten spezifizierten Oberflächenelement für zumindest eines der Vielzahl an Oberflächenelementen errechnet, wobei der errechnete Messdatenfehler auf einer oder beiden einer vorhandenen Breite der Messpunktgruppendaten im durch die Messdaten spezifizierten Oberflächenelement und einem Winkelfehler von einer Oberfläche oder einer Achse des durch die Messdaten spezifizierten Oberflächenelements relativ zu entweder einer Bezugsfläche oder einer Bezugsachse basiert;
ein Bestimmungscodesegment, das, wenn vom Computer ausgeführt, bestimmt, ob der errechnete Fehler innerhalb einer vorbestimmten Toleranz liegt;
ein Korrekturcodesegment, das, wenn vom Computer ausgeführt, das Oberflächenelement durch den Fehler korrigiert, wenn der Fehler innerhalb der Toleranz liegt; und
ein Codeinholungssegment, das, wenn vom Computer ausgeführt, Schnittdaten der Vielzahl an Oberflächenelementen und Konturdaten jedes Oberflächenelements von den korrigierten Oberflächenelementen zur Erzeugung eines 3D-Modells erhält.

## Revendications

1. Méthode de génération d'un modèle tridimensionnel (3D), comprenant :
l'entrée, par un ordinateur, de données de mesure pour une pluralité d'éléments de surface, les données de mesure comprenant des données de groupe de points de mesure obtenues par la mesure d'un objet mesuré, un type d'élément de surface, et une valeur géométrique d'un élément de surface ;
le calcul par l'ordinateur, pour au moins un de la pluralité d'éléments de surface, d'une erreur de données de mesure sur la base de l'élément de surface spécifié par les données de mesure, l'erreur calculée de données de mesure étant basée sur une des suivantes, ou les deux : une largeur existante des données de groupe de points de mesure dans l'élément de surface spécifié par les données de mesure, et une erreur angulaire de l'une d'une surface et d'un axe de l'élément de surface spécifié par les données de mesure relativement à un des suivants : une surface de référence et un axe de référence ;
la détermination, par l'ordinateur, si l'erreur calculée est comprise dans une tolérance prédéterminée ;
la correction, par l'ordinateur, de l'élément de surface par l'erreur, lorsque l'erreur est comprise dans la tolérance ; et
l'obtention de données d'intersection de la pluralité d'éléments de surface et de données de contour de chaque élément de surface d'après les éléments de surface corrigés pour la génération, par l'ordinateur, d'une modèle 3D.

2. Méthode de génération du modèle 3D selon la revendication 1, l'élément de surface étant un élément de surface plan, la largeur existante du groupe de points de mesure étant déterminée dans une zone où les données de groupe de points de mesure sont projetées dans l'élément de surface spécifié par la valeur géométrique de l'élément de surface, et lorsque l'élément de surface est un des suivants : élément cylindrique ou élément conique, la largeur existante du groupe de points de mesure est déterminée dans une zone où les données de groupe de points de mesure sont projetées dans un axe de l'élément de surface spécifié par la valeur géométrique de l'élément de surface.

3. Méthode de génération du modèle 3D selon la revendication 1, dans laquelle, lorsqu'à la fois la largeur existante et l'erreur angulaire sont comprises dans les tolérances, une position de l'élément de surface est corrigée de façon qu'elle s'aligne avec un des suivants : la surface de référence ou l'axe de référence, la largeur existante étant celle des données de groupe de points de mesure dans l'élément de surface spécifié par les données de mesure, l'angle d'erreur étant un des suivants : la surface ou l'axe de l'élément de surface spécifié par les données de mesure relativement à un des suivants : la surface de référence ou l'axe de référence.

4. Méthode de génération du modèle 3D selon la revendication 3, l'élément de surface étant un élément de surface plan, la largeur existante du groupe de points de mesure étant déterminée dans une zone où les données de groupe de points de mesure sont projetées dans l'élément de surface spécifié par la valeur géométrique de l'élément de surface, et lorsque l'élément de surface est un des suivants : élément cylindrique ou élément conique, la largeur existante du groupe de points de mesure est déterminée dans une zone où les données de groupe de points de mesure sont projetées dans un axe de l'élément de surface spécifié par la valeur géométrique de l'élément de surface.

5. Méthode de génération du modèle 3D selon une quelconque des revendications 3 à 4, l'erreur angulaire de l'élément de surface relatif à un des suivants : surface de référence et axe de référence est déterminée selon qu'une erreur angulaire relative à un angle de 90° est égale ou inférieure à une valeur seuil prédéterminée pour la détermination de l'angle droit ou une erreur angulaire relative à un angle de 0° est égale ou inférieure à une valeur seuil prédéterminée pour une des suivantes : détermination parallèle ou identique, la correction étant effectuée dans l'ordre de priorité suivant : identique, parallèle et perpendiculaire.

6. Méthode de génération du modèle 3D selon la revendication 1, l'erreur de données de mesure calculée étant une valeur numérique égale ou inférieure à un nombre prédéterminé de chiffres décimaux d'une valeur de rayon d'un élément à surface courbe bidimensionnel rotatif, y compris un cylindre, un cône, une sphère et un tore, spécifiée par les données de mesure, et la correction de l'élément de surface étant un procédé dans lequel la valeur numérique égale ou inférieure au nombre de chiffres prédéterminé est arrondie.

7. Système de génération d'un modèle 3D générant un modèle 3D d'un objet dans un système de CAO, le système de génération d'un modèle 3D comprenant :
un dispositif de saisie de code configuré pour entrer des données de mesure pour une pluralité d'éléments de surface, les données de mesure comprenant des données de groupe de points de mesure obtenues par la mesure de l'objet, un type d'élément de surface, et une valeur géométrique d'un élément de surface ;
un dispositif de détermination configuré pour calculer, pour au moins un élément de la pluralité d'éléments de surface, une erreur de données de mesure basée sur l'élément de surface spécifié par les données de mesure, l'erreur calculée des données de mesure étant basée sur une ou les deux des suivants : une largeur existante des données de groupe de points de mesure dans l'élément de surface spécifié par les données de mesure, et une erreur angulaire d'un des suivants : une surface et un axe de l'élément de surface spécifié par les données de mesure relatives à un des suivants : une surface de référence et un axe de référence, et étant configuré en outre pour déterminer si l'erreur calculée est comprise dans une tolérance prédéterminée ;
un correcteur d'élément de surface configuré pour corriger l'élément de surface par l'erreur, lorsque l'erreur est comprise dans la tolérance ; et
un générateur configuré pour obtenir des données d'intersection de la pluralité des éléments de surface, et définir des données de chaque élément de surface d'après les éléments de surface corrigés pour la génération d'un modèle 3D.

8. Système selon la revendication7, adapté pour l'exécution d'une méthode selon une quelconque des revendications 1 à 6.

9. Au moins un support non transitoire lisible par ordinateur pour la génération d'un modèle 3D, le support comprenant :
un segment de saisie de code qui, lorsqu'il est exécuté par l'ordinateur, entre des données de mesure pour une pluralité d'éléments de surface, les données de mesure comprenant des données de groupe de points de mesure obtenues de la mesure d'un objet mesuré, un type d'élément de surface, et une valeur géométrique d'un élément de surface ;
un segment de calcul de code qui, lorsqu'il est exécuté par l'ordinateur, calcule, pour au moins un de la pluralité d'éléments de surface, une erreur de données de mesure sur la base de l'élément de surface spécifié par les données de mesure, l'erreur calculée de données de mesure étant basée sur une, ou les deux, des suivantes : une largeur existante des données de groupe de points de mesure dans l'élément de surface spécifié par les données de mesure, et une erreur angulaire de l'une d'une surface et d'un axe de l'élément de surface spécifié par les données de mesure relativement à un des suivants : une surface de référence et un axe de référence ;
un segment de détermination de code, qui, lorsqu'il est exécuté par l'ordinateur, détermine si l'erreur calculée est comprise dans une tolérance prédéterminée ;
un segment de correction de code, qui, lorsqu'il est exécuté par l'ordinateur, corrige l'élément de surface par l'erreur, lorsque l'erreur est comprise dans la tolérance ; et
un segment d'obtention de code, qui, lorsqu'il est exécuté par l'ordinateur, obtient des données d'intersection de la pluralité d'éléments de surface et de données de contour de chaque élément de surface d'après les éléments de surface corrigés pour la génération, par l'ordinateur, d'une modèle 3D.
